# EUROPÄISCHE PATENTSCHRIFT

(11) **EP 1 254 278 B1**
(45) Veröffentlichungstag und Bekanntmachung des Hinweises auf die Patenterteilung: **06.04.2005**
(21) Anmeldenummer: 00990634.8
(22) Anmeldetag: 02.12.2000
(51) Int. Cl.: C23C 16/50, G02F 1/1337

(54) **Modulator mit einer Flüssigkristallzelle, welche eine die Orientierung eines Flüssigkristalls beeinflussende Schicht aufweist**
Modulator with liquid crystal cell having a layer which influences the orientation of the liquid crystal
Modulateur avec cellule à cristaux liquides ayant une couche qui influence l'orientation des cristaux liquides.

(30) Priorität: 23.12.1999 DE 19962306
(43) Veröffentlichungstag der Anmeldung: 06.11.2002
(73) Patentinhaber: Deutsche Telekom AG, 53113 Bonn (DE)
(72) Erfinder: DULTZ, Wolfgang, 65936 Frankfurt am Main (DE); ONOKHOV, Arkady, St. Petersburg, 198097 (RU); HAASE, Wolfgang, 64354 Reinheim (DE); KONSHINA, Elena, St. Petersburg, 199155 (RU); WEYRAUCH, Thomas, Columbia, MD 21045 (US)
(86) Internationale Anmeldenummer: PCT/EP2000/012133
(87) Internationale Veröffentlichungsnummer: WO 2001/048263

(56) Entgegenhaltungen:
- DE-A- 3 138 556
- US-A- 4 980 041
- KONSHINA E A ET AL: "Novel alignment layers produced by CVD technique from hydrocarbon plasma" LIQUID CRYSTAL MATERIALS, DEVICES, AND APPLICATIONS V, SAN JOSE, CA, USA, 12-13 FEB. 1997, Bd. 3015, Seiten 52-60, XP001010727 Proceedings of the SPIE - The International Society for Optical Engineering, 1997, SPIE-Int. Soc. Opt. Eng, USA ISSN: 0277-786X
- ISAEV M V ET AL: "INFLUENCE OF THE SURFACE STRUCTURE OF CONDENSED FILMS ON THE ORIENTATION OF LIQUID CRYSTALS" SOVIET PHYSICS TECHNICAL PHYSICS,US,AMERICAN INSTITUTE OF PHYSICS. NEW YORK, Bd. 40, Nr. 10, 1. Oktober 1995 (1995-10-01), Seiten 1071-1073, XP000542895
- WATANABE R ET AL: "Plasma-polymerized films as orientating layers for liquid crystals" JAPANESE JOURNAL OF APPLIED PHYSICS, PART 1 (REGULAR PAPERS & SHORT NOTES), MARCH 1987, JAPAN, Bd. 26, Nr. 3, Seiten 373-376, XP000996936 ISSN: 0021-4922

## Beschreibung

Die Erfindung betrifft einen Modulator nach dem Oberbegriff des Anspruchs 1.

Flüssigkristalle werden heutzutage in einer Vielzahl von Vorrichtungen verwendet, beispielsweise in Anzeigen, Verschlüssen, Lichtventilen, Deflektoren und Wellenleitern.

Als Lichtventile arbeiten ortsauflösende Lichtmodulatoren, die in der Lage sind, optisch oder elektrisch vorliegende zweidimensionale Information, beispielsweise Bilder oder Muster parallel zu verarbeiten, wie es insbesondere für die optische Informationsverarbeitung und die optische Mustererkennung notwendig ist. Je nach Art des ortsauflösenden Lichtmodulators kann dieser eine nematische oder smektische planare Flüssigkeitsschicht umfassen, welche entweder zwischen transparenten Elektroden oder benachbart zu einer photoleitenden Halbleiterschicht angeordnet ist. Das Prinzip derartiger Lichtmodulatoren beruht auf dem Einwirken eines u.U. ortsabhängigen elektrischen Feldes auf den Flüssigkristall, wodurch sich über einen elektrooptischen Effekt dessen doppelbrechende Eigenschaften ortsabhängig ändern. Das elektrische Feld wird im Fall eines elektrisch angesteuerten Lichtmodulators, beispielsweise eines Phasenmodulators, mit strukturierten Elektroden und beim optisch angesteuerten Lichtmodulator mittels der strukturierten Beleuchtung eines Photoleiters erzeugt.

In den meisten Fällen der erwähnten optischen Vorrichtungen mit Flüssigkristallen muß eine einheitlich Molekülorientierung vorgegeben werden. Beispielsweise weist eine nematische Flüssigkristallschicht eine Fernordnung der Molekülausrichtung auf, die Lage des sogenannten Direktors, der den räumlichen Mittelwert dieser Ausrichtung beschreibt, ist jedoch unbestimmt und muß von außen eingestellt werden. Dies wird durch eine Flüssigkristall-Orientierungsschicht, an welcher der Flüssigkristall anliegt, erreicht, wobei die Schicht eine vorgegebene Orientierungsrichtung festlegt, welche die Ausrichtung des Direktors der Flüssigkristallmoleküle bestimmt.

Für die Herstellung einer derartigen Orientierungsschicht sind eine Vielzahl von Verfahren bekannt. Dabei können beispielsweise Kunststoffschichten durch lineares Reiben mit Watte (UK 1372 868) oder durch Teilchenbeschuß bzw. durch die Verwendung von optischen Techniken (FR 2206981) eine Vorzugsrichtung erhalten. Weiterhin wurde das schräge Aufbringen von dünnen Filmen (UK 14011404) oder auch das schräge Aufdampfen von Schichten im Vakuum (UK 1388077) zur Orientierung der Moleküle vorgeschlagen. Die Orientierungsschichten nach dem Stand der Technik können aus Polyimidharzen (FRG 263 8091 ), Cellulose (FRG 2431482), butylcellulose-dotierten Polymeren (JP 4-81167) bestehen und werden aus geeigneten Lösungen abgeschieden. In US 4038441 werden langkettige Polymermoleküle aus einem Monomerdampf unter streifender Inzidenz auf ein Substrat aufgebracht. Weiterhin sind Orientierungsschichten unter der Verwendung von flüssigen Monomeren aus der Gruppe der Methymethacrylate, Vinylmonomere, Silane, Chlorosilane und Siloxane bekannt, wobei das Polymer auch direkt im Vakuum verdampft werden kann (JP 5-21214), und in der Regel ein Erhitzen des Substrates, auf welches die Orientierungsschicht abgeschieden wird, auf die Polymerisationstemperatur durchgeführt werden muss.
Es hat sich herausgestellt, daß eine zu starke planare Orientierung der Flüssigkristallmoleküle, d.h. parallel zur Fläche der Orientierungsschicht, die Effizienz des Modulators reduzieren kann. Dies ist auch darauf zurückzuführen, daß bei einer zu starken Orientierung der Moleküle parallel zur Fläche der Orientierungsschichten diese insbesondere in der Nähe der Orientierungsschicht gehindert werden, sich aufgrund eines von außen angelegten elektrischen Feldes umzuorientieren, was auch den erreichbaren optischen Kontrast vermindert. Weiterhin kann die Bildung von Domänen in der Nähe des Substrates oder schlicht die senkrechte relative Lage des angreifenden elektrischen Feldes zum Direktor eine Umorientierung der Flüssigkristalle im angelegten elektrischen Feld vor allem in der Nähe der Orientierungsschicht erschweren oder gar verhindern.

Es ist deshalb häufig für die planare Orientierung von Flüssigkristallen vorteilhaft, wenn die durch die Orientierungsschicht vorgegebene Orientierungsrichtung des Direktors neben einer Komponente parallel zur Substratebene oder Orientierungsschichtebene auch eine Komponente senkrecht zu dieser Ebene aufweist und somit der Direktor der orientierten Moleküle leicht aus der Substratebene herausgekippt ist, wobei der optimale Kippwinkel Θ beispielsweise von den verwendeten Flüssigkristallen abhängt. Die mit den beschriebenen Verfahren hergestellten Orientierungsschichten mit den herkömmlichen Zusammensetzungen sind jedoch insbesondere nicht in der Lage, eine definierte und reproduzierbare Einstellung des Kippwinkels bereitzustellen.

Aufgabe der Erfindung ist es somit, die beschriebenen Nachteile von Flüssigkristall-Orientierungsschichten bzw. Flüssigkristallzellen, welche derartige Schichten aufweisen, zumindest zu vermindern

Die wird bereits mit einem Verfahren zur Herstellung einer Flüssigkristall-Orientierungsschicht auf einem Substrat durch Abscheidung in einem Plasma einer Gasentladung bzw. einer Flüssigkristallzelle, die wenigstens eine derartige Orientierungsschicht aufweist, erreicht. Zu diesem Zweck wird die Schicht mittels Gasentladung aus einem Gas abgeschieden, welches zumindest einen Kohlenwasserstoff, insbesondere einen monomeren Kohlenwasserstoff aufweist. Auf höchst überraschende Weise kann durch die Verwendung zumindest eines Kohlenwasserstoffes, insbesondere eines monomeren Kohlenwasserstoffes zur Erzeugung des Entladungsplasmas die Orientierungsrichtung der im Plasma der Gasentladung abgeschiedenen Schicht und damit der Kippwinkel der anliegenden Flüssigkristalle definiert und reproduzierbar eingestellt werden. Der für die jeweiligen Flüssigkristalle optimierte Kippwinkel lässt sich dabei während der Herstellung der Orientierungsschicht durch die Festlegung des Kohlenwasserstoffes, des Winkels α zwischen der Subtratebene und der mittleren Flussrichtung der Plasma-Ionen, und der Entladungsleistung W einstellen. Besonders vorteilhaft haben sich für Cyanobiphenyle Abscheidewinkel α zwischen etwa 5° und 10° und Gleichstrom-Entladungsleistungen zwischen 1,6 und 1,8 W herausgestellt.

Mit erfindungsgemäßen Orientierungschichten sind beispielsweise Modulatoren mit einem hohen Kontrast und mit einer niedrigeren Ansprechzeit im Vergleich zu Modulatoren nach dem Stand der Technik herstellbar.

Als monomerer Kohlenwasserstoff zur Erzeugung des Plasmas kann eine Vielzahl von i.d.R. leicht verfügbaren und nicht kostenintensiven Substanzen, beispielsweise Toluen-Dampf, Benzoldampf, Oktandampf oder eine Mischung daraus verwendet werden. Da weiterhin für die Abscheidung der Schichten herkömmliche Standard-Vakuumanlagen verwendet werden können und die Aufheizung des Substrates während der Abscheidung entfallen kann, lassen sich die erfindungsgemäßen Schichten bzw. Flüssigkristallzellen sehr günstig industriell herstellen.
Die abgeschiedenen Schichten umfassen im wesentlichen Kohlenwasserstoffpolymere, die kaum absorbieren und weiterhin isolierend sind. Die hohe Oberflächenenergie der Schichten erlaubt eine stabile planare Orientierung der Flüssigkristallmoleküle aufgrund intermolekularer Kräfte an der Kontaktschicht zwischen der abgeschiedenen Orientierungsschicht und den Flüssigkristallen.
Die reproduzierbare und definierte Einstellung des Kippwinkels durch das erfindungsgemäße Abscheiden der Orientierungsschicht ist auch bei einer Beschichtung in Kontakt auf eine transparente leitfähige Elektrodenschicht, eine photoleitfähige Halbleiterschicht, eine lichtreflektierende Schicht oder auch direkt auf das Substrat möglich. Vorteilhafterweise werden dabei die Eigenschaften der unter der erfindungsgemäßen Orientierungschicht liegenden Schichten, beispielsweise einer transparenten Elektrode oder einer Photohalbleiterschicht nicht verändert. Somit lassen sich alle Flüssigkristallzellen, insbesondere transmittive und reflektive Modulatoren mit erfindungsgemäß hergestellten Orientierungsschichten produzieren.

Zur Ausnutzung des sogenannten S-Effektes können die sich gegenüberliegenden, den Flüssigkristall einschließenden Substrate jeweils eine Orientierungsschicht aufweisen, die so orientiert sind, daß die beiden Orientierungsrichtungen parallel zueinander liegen.
Zur Ausnutzung des sogenannten Twist-Effektes können die Substrate mit den jeweiligen Orientierungsschichten so zueinander angeordnet sein, daß die beiden Orientierungsrichtungen senkrecht zueinander stehen.

Zur Erreichung eines hohen Kontrastes können beide Substrate der erfindungsgemäßen "S"-Flüssigkristallzelle eine erfindungsgemäße Orientierungsschicht aufweisen, wobei der Winkel α bei der Beschichtung des ersten Substrates auf etwa 90° und bei der Beschichtung des zweiten Substrates auf etwa 10° eingestellt ist. Um eine geringe Ansprechzeit der "S"-Flüssigkristallzelle einzustellen, können beide Orientierungsschichten unter einem Winkel von α etwa 10° aufgebracht werden.

Die Verwendung einer erfindungsgemäß hergestellten Flüssigkristall-Orientierungsschicht für einen optisch adressierbaren, insbesondere ortsauflösenden Modulator bzw. einen elektrisch adressierbaren, insbesondere ortsauflösenden Modulator ist nur beispielhaft, die erfindungsgemäße Flüssigkristall- Orientierungsschicht kann prinzipiell für alle bekannten Flüssigkristallzellen Verwendung finden.

Die Erfindung wird im Folgenden durch das Beschreiben einiger Ausführungsformen unter Zugrundelegen der Zeichnungen erläutert, wobei
- Fig. 1: den Beschichtungsaufbau in einer Prinzipskizze darstellt,
- Fig. 2: den gemessenen Kippwinkel θ in Abhängigkeit der Entladungsleistung bei festem Abscheidungswinkel α zeigt,
- Fig. 3: einen elektrisch ansteuerbaren Modulator zur Ausnutzung des S-Effektes,
- Fig. 4: einen elektrisch ansteuerbaren Modulator zur Ausnutzung des Twist-Effektes und
- Fig. 5: einen optisch adressierbaren, ortsauflösenden Modulator zeigt, sowie
- Fig. 6: die gemessenen Modulationstiefen von zwei Modulatoren nach der in Fig. 3 dargestellten Bauart zeigt.

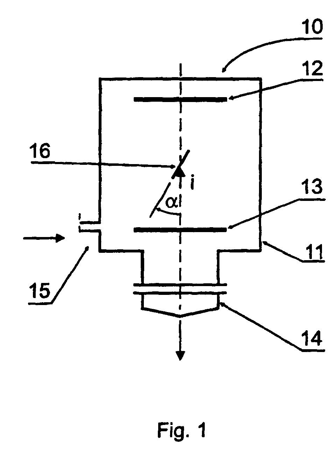

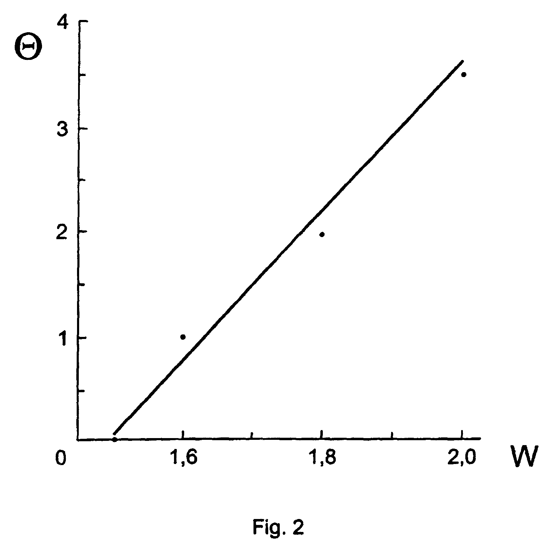

Fig. 1 zeigt in einer schematischen Darstellung eine Apparatur zur Ausführung des erfindungsgemäßen Verfahrens zur Herstellung einer Flüssigkristall-Orientierungsschicht auf einem Substrat durch die Abscheidung von Atomen, Molekülen und/oder Polymeren aus einem Plasma einer Gasentladung in Form einer Glimmentladung. Sie weist eine Kammer 11 auf, weiche mittels einer nicht dargestellten, an den Anschlußstutzen 14 angeschlossenen Pumpe entlüftet werden kann. Beabstandet sind eine Kathode 12 und eine Anode 13 in der Vakuumkammer 11 angeordnet, zwischen die eine Hochspannung angelegt wird. Das Entladungsgas wird über einen Einfüllstutzen 15 der Vakuumkammer 11 zugeführt und umfasst im beschriebenen Beispiel einen monomeren Kohlenwasserstoff in Form von Toluen-Dampf. Zwischen Anode und Kathode ist ein Substrathalter 16 angeordnet, welcher um eine Achse, die senkrecht zur Zeichenebene liegt, schwenkbar gelagert ist.
Die Erzeugung einer Gasentladung in der beschriebenen Apparatur ist dem Fachmann wohlbekannt, so daß im weiteren darauf nicht eingegangen werden muß. Die Gasentladung hat einen Ionen- und Elektronenstrom zwischen den beiden Elektroden 12, 13 zur Folge, wobei die raumgemittelte Flußrichtung von Ladungsträgern als Vektor i bezeichnet ist. Zur Beschichtung eines Substrates wird dieses vom Substrathalter 16 aufgenommen. Die Ladungsträger, d.h. Ionen aus dem Plasma des Toluen-Dampfes treffen unter einem vorgegebenen Winkel α auf das Substrat auf und werden im wesentlichen als dielektrisches Kohlenwasserstoffpolymer bzw. Polymere auf dem Substrat abgeschieden. Die Orientierungsrichtung liegt dabei innerhalb der durch den Vektor i und der Flächennormalen des Substrates definierten Ebene, d.h. in der Zeichnungsebene der Fig. 1. Der Kippwinkel, d.h. die Ausrichtung des Direktors des vorgegebenen Flüssigkristalls aus der Orientierungsschicht heraus wird nach der Wahl des Kohlenwasserstoffs für die Glimmentladung einerseits durch das Einstellen des Winkels α, dem Winkel zwischen der Flussrichtung i und der Substratebene und durch das Einstellen der Entladungsleistung festgelegt. Für die erfindungsgemäße Abscheidung der Orientierungsschicht kann die sonst übliche und notwendige Aufheizung des Substrates entfallen und bei Zimmertemperatur stattfinden.
Die beispielhafte Abhängigkeit des Kippwinkels θ von der Entladungsleistung W zeigt Fig. 2 für eine 10 µm dicke Flüssigkristallzelle des S-Typs mit Cyanobiphenylen, wobei beide Orientierungsschichten bei einem vorbestimmten Winkel α=10° hergestellt wurden. Der Kippwinkel verläuft innerhalb eines Bereichs zwischen etwa 1,3 und 2,0 Watt linear mit der Entladungsleistung und liegt für die genannten Entladungsleistungen im Bereich von 0 bis etwa 3,5°.

Beträgt der Winkel α etwa 90°, so ist keine Ebene ausgezeichnet, da die Einstrahlebene des Ladungsträgerflusses sich zu einer Geraden reduziert, demnach ist keine Orientierungsrichtung durch die Orientierungsschicht ausgezeichnet.

Je nach Ausführungsform der Erfindung kann zur Erzeugung des Plasmas bzw. der auf dem Substrat abzuscheidenden Substanzen verschiedene monomere, unter Normalbedingungen flüssige oder gasförmige Kohlenwasserstoffe, beispielsweise Toluen, Benzol, Oktan usw. verwendet werden. In allen Fällen sind die erzeugten Orientierungsschicht homogen und im sichtbaren Spektralbereich transparent, der Extinktionskoeffizient liegt zwischen 0,01 und 0,03. Der Brechungsindex der erzeugten Schichten liegt zwischen 1,5 und 1,6. Die Schichten sind hochisolierend mit einem Flächenwiderstand von größer 10¹² Ωcm. Die hohe Oberflächenenergie der Schichten von etwa 43 J/m² erlaubt eine stabile, im wesentlichen planare Orientierung der Flüssigkristallmoleküle in Folge der intermolekularen Kräfte an der Kontaktschicht zwischen der Orientierungsschicht und den Flüssigkristallen. Durch die erfindungsgemäße Orientierungsschicht bei einem Abscheidungswinkel von α = 5° -10° und Entladungsleistungen von 1,6 bis 1,8 Watt ist der Direktor der Flüssigkristalle um einen kleinen Kippwinkel θ für einen Flüssigkristall auf der Basis von Cianobiphenylen mit einer Dicke von 10 µm um 0° bis 2° aus der Substratebene gekippt. Bei erhöhter Glimmentladungsleistung von 2,2 Watt vergrößert sich der Kippwinkel Θ des Flüssigkristalldirektors um nicht mehr als 3,5°.

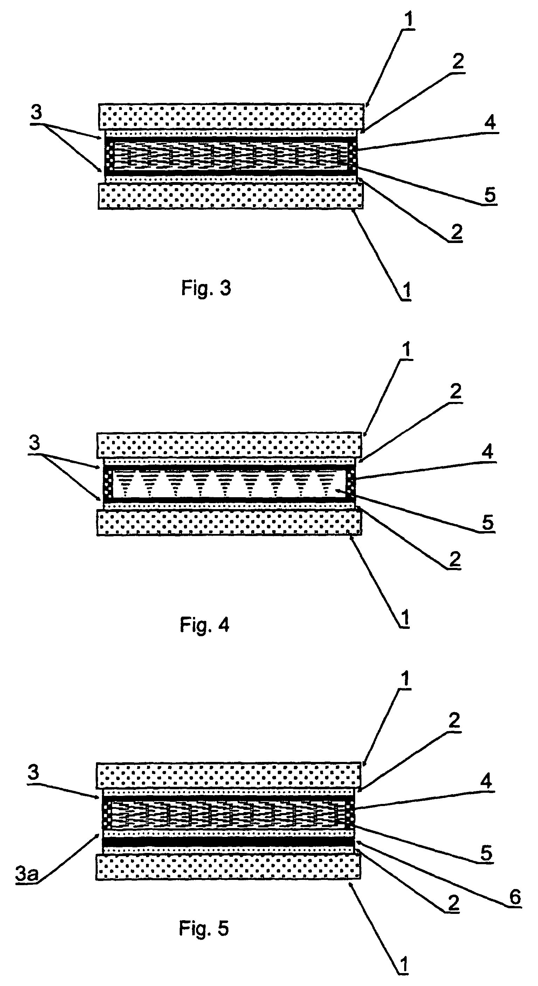

Fig. 3 zeigt einen elektrisch adressierbaren Modulator, welcher auf der Basis des sogenannten S-Effektes arbeitet. Dabei umfaßt die erfindungsgemäße Flüssigkristallzelle zwei Glassubstrate 1 von 35 mm Durchmesser , auf welche jeweils eine transparente Elektrode 2 aus Indium-Zinn-Oxyd abgeschieden ist. Auf der transparenten Elektrode wurde aus dem Toluendampf im Plasma einer Glimmentladung eine erfindungsgemäße Orientierungsschicht 3 abgeschieden. Für beide Orientierungsschichten war der Winkel α auf 10° eingestellt, siehe Fig. 1. Die beiden Glassubstrate sind zueinander so orientiert angeordnet, daß die Orientierungsrichtungen, d.h. die Vorzugsrichtungen für den Direktor der Flüssigkristalle parallel liegen. Abstandshalter 5 aus Teflon mit einer Dicke von 5µm legen zusammen mit den Substraten ein Volumen fest, in welches eine Flüssigkristallmischung aus Cyanobiphenylen in der isotropen Phase durch ein Loch nach der bekannten Kapillartechnik eingefüllt wird. Die Zelle wurde mit einem Epoxyzement an den Kanten verschlossen. Das Anlegen eines elektrischen Feldes in bekannter Weise an die Elektroden verursacht eine Umorientierung der Moleküle im elektrischen Feld derart, daß diese aus ihrer Lage parallel zum Substrat bzw. der Orientierungsschicht senkrecht dazu gestellt werden, womit die optische Anisotropie und damit die Doppelbrechung aufgehoben wird.

Die Arbeitsfrequenz des Modulators wurde bestimmt, indem das Zeitintervall zwischen dem Anlegen der Arbeitsspannung und dem Erreichen eines Bildkontrasts von 0,8 bis 0,9 des maximalen Wertes bei Dauerbetrieb gemessen wurde. In ähnlicher Weise wurde beim Abschalten der Spannung die Zeitdauer bestimmt, nach welcher der Bildkontrast auf das 0,1 bis 0,2-fache des maximalen Wertes abgesunken war. Die so bestimmte Anschaltzeit betrug 200 µsek, die Abschaltzeit 20 msek.

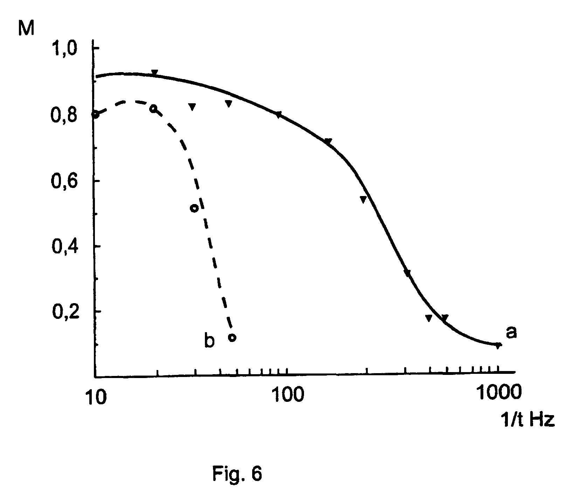

Die Abhängigkeit der Modulationstiefe für den in Fig. 3 gezeigten elektrisch adressierbaren Modulator von der angelegten Frequenz zeigt die Kurve a) in Fig. 6. Werden beide Orientierungsschichten unter dem Winkel α=10° bei einer Glimmentladungsleistung von 1,5 W aufgebracht, so ergibt sich bei 250 Hertz eine Modulationstiefe von M=0,5 und bei 1000 Hertz von M=0,1.

Wird dagegen eine der beiden Schichten statt dessen unter einem Winkel von α=90° abgeschieden, so ergibt sich ein höherer Kontrast, die entsprechenden Frequenzen verringern sich jedoch auf 30 Hz für M=0,5 und 50 Hz für M=0,1, siehe Kurve b) der Fig. 6. Die Zeitkonstanten für elektrisch und optisch adressierbare Modulatoren differieren nicht wesentlich.

Fig. 4 zeigt den Aufbau eines elektrisch adressierbaren Modulators, welcher auf dem sogenannten Twist-Effekt beruht. Dieser unterscheidet sich zu dem in Fig. 3 dargestellten Modulator nur dadurch, daß die beiden Orientierungsrichtungen der Schichten senkrecht zueinander liegen, so daß die Flüssigkristalle im Verlauf von der einen Begrenzungsschicht zur anderen eine Drehung um 90° vollziehen. In Fig. 4 liegt demnach der Direktor der Flüssigkristalle an der unteren Begrenzungsschicht senkrecht zur Zeichnungsebene, während er in der oberen Begrenzungsschicht parallel zur Zeichnungsebene liegt. Licht, welches durch den Modulator hindurch transmittiert, dreht entsprechend der Drehung der Flüssigkristalle seine Polarisation, während beim Anlegen einer elektrischen Spannung die Moleküle wiederum in normaler Richtung zur Substratoberfläche umorientiert werden, wodurch die Drehung des transmittierenden Lichtes entfällt. Es wurde festgestellt, daß erfindungsgemäße ausgebildete Flüssigkristallzellen eine feste Verankerung und Orientierung der Flüssigkristalle aufweisen. Bei Rechteckimpulsen mit einer Amplitude von 20 Volt und einer Dauer von 2 msek wurde ein Anschaltzeit von 50 µsek und eine Abschaltzeit von 100 µsek gemessen.

Fig. 5 zeigt den Aufbau eines optisch adressierbaren Modulators, welcher auf dem S-Effekt beruht. Wiederum umfaßt ein Substrat 1 eine transparente Elektrode 2, auf welche eine erfindungsgemäße Orientierungsschicht 3 wie die in Fig. 3 aufgetragen wurde. Das andere Glassubstrat war wiederum mit einer transparenten Elektrode 2 ausgestattet, auf welche eine polymere Photohalbleiterschicht 6 aufgedampft wurde, auf die eine erfindungsgemäße Orientierungsschicht aus einem Toluen-Dampf im Plasma unter normaler Inzidenz, d.h. α=90° abgeschieden wurde. Darüber hinaus entsprach die in Fig. 5 dargestellte Zelle in ihrem technischen Aufbau der in Fig. 3 gezeigten Flüssigkristallzelle. Demnach wies die Flüssigkristallschicht eine gleichmäßige parallel Orientierung auf, solange der Photoleiter nicht von seiner rückwärtigen Seite, d.h. in der Zeichnung von unten, beispielsweise durch Abbilden eines Gitters beleuchtet wurde. Zur Messung der Zeitkonstanten wurde während der Beleuchtung des Photoleiters an die Elektroden eine Spannung in Form eines Rechteckimpulses mit einer Amplitude von 30 Volt und einer Zeitdauer von 20 msek angelegt, wobei die Wiederholungsrate 2 Hz betrug. Die Anstiegszeit für das Erreichen des 0,1 bis 0,9-fachen der maximalen Beugungseffizienz betrug 500 msek und die entsprechende Abstiegszeit zum Erreichen des 0,9 bis 0,1-fachen der maximalen Beugungseffizienz wurde zu 20 msek bestimmt. Durch die erfindungsgemäßen Orientierungsschichten verkürzen sich die Ansprechzeiten der Modulatoren im Vergleich zu Modulatoren nach dem Stand der Technik.

Die Qualität der Funktion der so hergestellten Modulatoren macht ihren Einsatz in der optischen Informationsbearbeitung, der Lichtdetektion, der Lichtübertragung und der Lichtverstärkung attraktiv.

## Patentansprüche

1. Modulator, aufgebaut als optisch oder elektrisch adressierbarer, insbesondere ortsauflösender Modulator, umfassend eine Flüssigkristallzelle mit einem durch zwei sich flächig erstreckende, beabstandet gehaltene Substrate (1) und zumindest ein Abstandselement (5) gebildeten Volumen, in dem eine vorgegebene Menge Flüssigkristall (4) angeordnet ist und zumindest ein Substrat transparent ist,
wobei wenigstens ein Substrat (1) eine Flüssigkristall-Orientierungsschicht (3, 3a) aufweist, die wenigstens ein Kohlenwasserstoffpolymer umfasst, und wobei die Flüssigkristall-Orientierungsschicht (3, 3a) auf der dem Flüssigkristall (4) zugewandten Seite angeordnet ist,
**dadurch gekennzeichnet, daß** die Flüssigkristall-Orientierungsschicht (3, 3a) durch Abscheidung aus einer Glimmentladung hergestellt ist, wobei der Winkel α zwischen der Substratebene und einer mittleren Flußrichtung i des Entladungstromes auf 0° bis 90°, vorzugsweise 5° bis 10° eingestellt wird.

2. Modulator nach Anspruch 1, welcher als optisch adressierbarer, insbesondere ortsauflösender Modulator aufgebaut ist, **dadurch gekennzeichnet, dass** das erste Substrat (1) ausgehend von diesem die aufgebrachten Schichten transparente elektrisch leitfähige Elektrodenschicht (2) , photoleitende Halbleiterschicht (6) und Flüssigkristall-Orientierungsschicht (3a) aufweist und das zweite Substrat (1) ausgehend von diesem die aufgebrachten Schichten elektrisch leitfähige Elektrodenschicht (2) und Flüssigkristall-Orientierungsschicht (3) aufweist.

3. Modulator nach Anspruch 1,
welcher als elektrisch adressierbarer, insbesondere ortsauflösender Modulator aufgebaut ist, **dadurch gekennzeichnet, dass** beide Substrate (1) ausgehend vom jeweiligen Substrat die aufgebrachten Schichten transparente elektrisch leitfähige Elektrodenschicht (2) und Flüssigkristall- Orientierungsschicht (3) aufweisen.

4. Modulator nach einem der Ansprüche 1 bis 3,
**dadurch gekennzeichnet, dass**
die Flüssigkristall-Orientierungsschicht (3, 3a) aus einem Gas abgeschieden ist, das Kohlenwasserstoff, insbesondere monomeren Kohlenwasserstoff umfasst.

5. Modulator nach einem der Ansprüche 1 bis 4,
**dadurch gekennzeichnet, dass**
durch Einstellen des Winkels α auf etwa 5° bis 10 ° und Einstellen der Entladungsleistung zwischen 1,4 und 2,2 W die Flüssigkristall-Orientierungsschicht (3, 3a) einen Kippwinkel θ zwischen 0 und 3,5 Grad aufweist.

6. Modulator nach einem der Ansprüche 1 bis 5,
**dadurch gekennzeichnet, dass**
als Kohlenwasserstoff ein Toluendampf, ein Benzoldampf und/oder ein Oktandampf verwendet wird.

7. Modulator nach einem der Ansprüche 1 bis 6,
**dadurch gekennzeichnet, dass**
die Orientierungsschicht (3, 3a) in Kontakt auf eine transparente leitfähige Elektrodenschicht (2), eine photoleitfähige Halbleiterschicht (6) oder eine lichtreflektierende Schicht, mit welcher jeweils das Substrat beschichtet ist, abgeschieden ist.

8. Modulator nach einem der Ansprüche 1 bis 7,
**dadurch gekennzeichnet, dass**
beide Substrate (1) eine Orientierungsschicht (3, 3a) aufweisen, wobei die Substrate so angeordnet sind,
dass die jeweilige Orientierungsrichtung der Orientierungschichten im wesentlichen parallel zueinander liegen.

9. Modulator nach einem der Ansprüche 1 bis 7,
**dadurch gekennzeichnet, dass**
beide Substrate (1) eine Orientierungsschicht (3, 3a) aufweisen, wobei die Substrate so angeordnet sind,
dass die jeweilige Orientierungsrichtung der Orientierungschichten senkrecht zueinander, im wesentlichen in der Substratebene, liegen.

## Claims

1. Modulator, in the form of an optically or electrically addressable modulator, more particularly an optically or electrically addressable spatial light modulator, comprising a liquid-crystal cell with a space formed by two two-dimensionally extending, spaced-apart substrates (1) and at least one spacing element (5), in which space is disposed a specified quantity of liquid crystal (4) and in which space at least one substrate is transparent, at least one substrate (1) having a liquid-crystal orientation layer (3, 3a) comprising at least one hydrocarbon polymer and the liquid-crystal orientation layer (3, 3a) being disposed on the side facing the liquid crystal (4),
**characterized in that** the liquid-crystal orientation layer (3, 3a) is produced through deposition from a glow discharge, the angle α between the substrate plane and a mean flow direction i of the discharge current being adjusted to 0° to 90°, preferably to 5° to 10°.

2. Modulator according to claim 1, said modulator being in the form of an optically addressable modulator, more particularly an optically addressable spatial light modulator, **characterized in that**, starting from the first substrate (1), said first substrate has the applied layers of transparent electrically conductive electrode layer (2), photoconductive semiconductor layer (6) and liquid-crystal orientation layer (3a) and, starting from the second substrate (1), said second substrate has the applied layers of electrically conductive electrode layer (2) and liquid-crystal orientation layer (3).

3. Modulator according to claim 1,
said modulator being in the form of an electrically addressable modulator, more particularly an electrically addressable spatial light modulator, **characterized in that**, starting from the respective substrate, both substrates (1) have the applied layers of transparent electrically conductive electrode layer (2) and liquid-crystal orientation layer (3).

4. Modulator according to any one of claims 1 to 3, **characterized in that**
the liquid-crystal orientation layer (3, 3a) is deposited from a gas comprising hydrocarbon, more particularly monomeric hydrocarbon.

5. Modulator according to any one of claims 1 to 4, **characterized in that**
by adjusting the angle α to approximately 5° to 10° and by adjusting the discharge power to between 1.4 and 2.2 W, the liquid-crystal orientation layer (3, 3a) has a tilt angle θ between 0 and 3.5 degrees.

6. Modulator according to any one of claims 1 to 5, **characterized in that**
a toluene vapour, a benzene vapour and/or an octane vapour is used as hydrocarbon.

7. Modulator according to any one of claims 1 to 6, **characterized in that**
the orientation layer (3, 3 a) is deposited in contact onto a transparent conductive electrode layer (2), a photoconductive semiconductor layer (6) or a light-reflecting layer with which the respective substrate is coated.

8. Modulator according to any one of claims 1 to 7, **characterized in that**
both substrates (1) have an orientation layer (3, 3a), the substrates being so disposed that the respective orientation directions of the orientation layers are substantially parallel to each other.

9. Modulator according to any one of claims 1 to 7, **characterized in that**
both substrates (1) have an orientation layer (3, 3a), the substrates being so disposed that the respective orientation directions of the orientation layers are perpendicular to each other, substantially in the substrate plane.

## Revendications

1. Modulateur monté comme modulateur à adressage optique ou électrique et notamment comme modulateur spatial de lumière, comprenant une cellule à cristal liquide avec un volume formé de deux substrats (1) s'étendant en surface et maintenus espacés l'un par rapport à l'autre et d'au moins un élément d'espacement (5), dans lequel volume est disposée une quantité préétablie de cristal liquide (4) et où au moins un substrat est transparent, au moins un substrat (1) présentant une couche d'orientation des cristaux liquides (3, 3a) comprenant au moins un polymère d'hydrocarbure et la couche d'orientation des cristaux liquides (3, 3a) étant disposée sur le côté tourné vers le cristal liquide (4),
**caractérisé en ce que** la couche d'orientation des cristaux liquides (3, 3a) est générée par dépôt à partir d'une décharge luminescente, l'angle α entre le plan du substrat et une direction de flux moyenne i du courant de décharge étant ajusté à 0° à 90°, de préférence à 5° à 10°.

2. Modulateur selon la revendication 1, monté comme modulateur à adressage optique et notamment comme modulateur spatial de lumière, **caractérisé en ce que** le premier substrat (1) présente, à partir de celui-ci, les couches appliquées couche d'électrode transparente électriquement conductible (2), couche de semi-conducteur photoconductrice (6) et couche d'orientation des cristaux liquides (3).

3. Modulateur selon la revendication 1,
monté comme modulateur à adressage électrique et notamment comme modulateur spatial de lumière,
**caractérisé en ce que** les deux substrats (1) présentent, à partir du substrat respectif, les couches appliquées couche d'électrode transparente électriquement conductible (2) et couche d'orientation des cristaux liquides (3).

4. Modulateur selon l'une des revendications 1 à 3,
**caractérisé en ce que**
la couche d'orientation des cristaux liquides (3, 3a) provient d'un gaz contenant un hydrocarbure, notamment un hydrocarbure monomère.

5. Modulateur selon l'une des revendications 1 à 4,
**caractérisé en ce que**,
par ajustement de l'angle α à environ 5°à 10° et ajustement de la puissance de décharge entre 1,4 et 2,2 W, la couche d'orientation des cristaux liquides (3, 3a) présente un angle de angle d'inclinaison θ compris entre 0 et 3,5 degrés.

6. Modulateur selon l'une des revendications 1 à 5,
**caractérisé en ce que**,
l'on prend comme hydrocarbure une vapeur de toluène, une vapeur de benzène et/ou une vapeur d'octane.

7. Modulateur selon l'une des revendications 1 à 6,
**caractérisé en ce que**
la couche d'orientation (3, 3a) est déposée en contact avec une couche d'électrode transparente électriquement conductible (2), une couche de semi-conducteur photoconductrice (6) ou une couche réfléchissant la lumière apposée respectivement sur le substrat.

8. Modulateur selon l'une des revendications 1 à 7,
**caractérisé en ce que**
les deux substrats (1) présentent une couche d'orientation (3, 3a), les substrats étant disposés de telle façon que les couches d'orientation aient des sens d'orientation sensiblement parallèles.

9. Modulateur selon l'une des revendications 1 à 7,
**caractérisé en ce que**
les deux substrats (1) présentent une couche d'orientation (3, 3a), les substrats étant disposés de telle façon que les couches d'orientation aient des sens d'orientation perpendiculaires, sensiblement dans le plan des substrats.
